# EUROPEAN PATENT APPLICATION

(11) **EP 3 147 947 A1**
(43) Date of publication of application: **29.03.2017**
(21) Application number: 16167730.7
(22) Date of filing: 29.04.2016
(51) Int. Cl.: H01L 27/32, G06F 3/041

(54) **ORGANIC LIGHT EMITTING DISPLAY DEVICE AND METHOD FOR MANUFACTURING THE SAME**

(30) Priority: 25.09.2015 CN 201510618243
(71) Applicant: EverDisplay Optronics (Shanghai) Limited, Shanghai 201500 (CN)
(72) Inventor: SU, Wei Sheng, 201500 Shanghai (CN); CHEN, Jr-Hong, 201500 Shanghai (CN)
(74) Representative: Clarenbach, Carl-Philipp

(57) **Abstract**

The present disclosure relates to an organic light emitting display (OLED) device and a method for manufacturing the same, and an electronic apparatus employing the OLED device. The OLED device according to the present disclosure includes a touch screen (50), a display panel (40), a circuit board (10) and a plurality of pressure sensors (20). A lower surface of the display panel (40) is applied with an adhesive layer (30), an upper layer of the flexible circuit board (10) is adhered to the adhesive layer (30), and the plurality of pressure sensors (20) are disposed in the adhesive layer (30). According to the OLED device of the present disclosure, pressure sensors are disposed under the display panel with a simple structure without occupying the frame position of the cover glass.

## Description

### TECHNICAL FIELD

The present disclosure relates to an organic light emitting display (OLED) device and a method for manufacturing the same, and an electronic apparatus employing the OLED device.

### BACKGROUND

Recently, since the development of a new generation touching technology, i.e., the touch sensing technology, the touching devices may sense the force of a light press and a hard press and activate different functions correspondingly.

However, in the current touching devices, pressure sensors are generally disposed under four corners of a cover glass to judge a magnitude of the force and the direction and position of the applied force. However, such a product is disadvantageous in that it is impossible to narrow frames of the product and other processes are required for the mechanism design.

### SUMMARY

Accordingly, the present invention provides an OLED device and a method for manufacturing the same, and an electronic apparatus employing the OLED device, in accordance with claims which follow.

With respect to the above problems and/or other problems in the prior art, one aspect of the present disclosure provides an organic light emitting display (OLED) device including: a touch screen; a display panel having an upper surface attached to a lower surface of the touch screen and a lower surface applied with an adhesive layer; a circuit board having an upper surface adhered to the adhesive layer; and a plurality of pressure sensors disposed in the adhesive layer.

Preferably, the plurality of pressure sensors are adhered to the upper surface of the circuit board.

Preferably, the display panel includes four corners, and the pressure sensors are respectively disposed under the four corners.

Preferably, lower surfaces of the four corners of the display panel are in contact with the pressure sensors.

Preferably, the OLED device is an AMOLED display device.

Preferably, the circuit board is a flexible based circuit board.

Preferably, the OLED device further includes a transparent cover plate disposed on the touch screen.

Preferably, the transparent cover plate is formed of glass or acryl.

Another aspect of the present disclosure provides a method for manufacturing an organic light emitting display (OLED) device, the method including: step 1A, providing a circuit board with a plurality of pressure sensors thereon; step 1B, providing a display panel combined with a touch screen; and step 2, adhering the circuit board to the display panel through an adhesive layer, such that the plurality of pressure sensors are disposed between the circuit board and the display panel and imbedded in the adhesive layer..

Preferably, after the step 1B, the method further include: step 1C, providing the adhesive layer attached on the display panel.

Preferably, in the step 2, the plurality of pressure sensors are imbedded into the adhesive layer to direct in contact with the display pane.

Preferably, the OLED device is an AMOLED display device.

Preferably, the circuit board is a flexible based circuit board.

A further aspect of the present disclosure provides an electronic apparatus including the above OLED device.

According to the OLED device of the present disclosure, pressure sensors are disposed under the display panel with a simple structure without occupying the frame position of the cover glass. Accordingly, frame of the cover glass may be arbitrarily reduced, thereby increasing the ratio of the display screen and improving user experience. The structure of the present disclosure is particularly suitable for AMOLED devices.

### BRIEF DESCRIPTION OF THE DRAWINGS

Fig. 1 is a cross sectional structural diagram of an OLED device of embodiment 1 of the present disclosure;
Fig. 2 is a top structural diagram of the OLED device of embodiment 1 of the present disclosure;
Fig. 3 is a schematic diagram of step 1A of a method for manufacturing the OLED device of embodiment 1 of the present disclosure;
Fig. 4 is a schematic diagram of step 1C of the method for manufacturing the OLED device of embodiment 1 of the present disclosure;
Fig. 5 is a schematic diagram of step 2 of the method for manufacturing the OLED device of embodiment I of the present disclosure; and
Fig. 6 is a cross sectional structural diagram of an OLED device of embodiment 2 of the present disclosure.

### DETAILED DESCRIPTION

Example implementations will now be described more fully with reference to the accompanying drawings. However, the example implementations can be implemented in various forms, and should not be interpreted as being limited to the implementations set forth herein; on the contrary, these implementations are provided such that the present disclosure will be thorough and complete, and will fully convey the concept of the example implementations to those skilled in the art. In the drawings, the same reference numerals denote the same or like structures, and thus their repeated description will be omitted.

The described features, structures or characters may be combined in one or more implementations in any suitable manner. In the following description, numerous specific details are provided so as to allow a full understanding of the implementations of the present disclosure. However, those skilled in the art will recognize that the technical solutions of the present disclosure may be implemented without one or more of the specific details, or other methods, components, materials and so on may be used. In some cases, the well-known structures, materials or operations are not shown or described in detail to avoid obscuring the present disclosure.

Drawings of the present disclosure are provided for illustrating relative position relations and electrical connection relations only, the thickness of the layers at some portions are exaggerated for ease of understanding, and the thickness in the drawings does not indicate actual scale of the thickness of layers.

### Embodiment 1

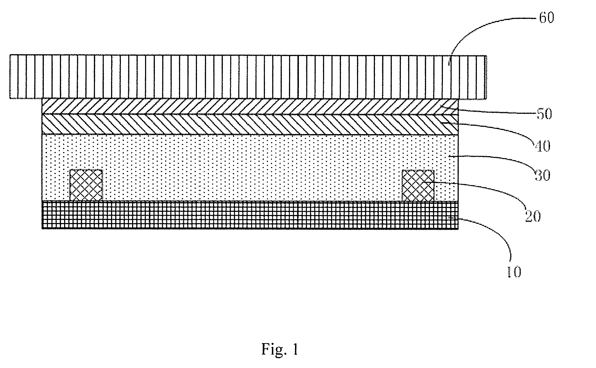

Referring to Fig. 1, which is a structural diagram of an OLED device of embodiment 1 of the present disclosure. The OLED device includes a touch screen 50, a display panel 40, an adhesive layer 30, a flexible circuit board 10 and a plurality of pressure sensors 20.

In the embodiment, an upper surface of the display panel 40 is attached to a lower surface of the touch screen 50. A lower surface of the display panel 40 is applied with the adhesive layer 30. An upper surface of the flexible circuit board 10 is adhered to the adhesive layer 30. The plurality of pressure sensors 20 are disposed in the adhesive layer 30.

In the present embodiment, a transparent cover plate 60 is disposed on the touch screen 50. The transparent cover plate 60 may be formed of glass, acryl or the like, but is not limited thereto.

Preferably, as illustrated in Fig. 1, the plurality of pressure sensors 20 are adhered to the upper surface of the flexible circuit board 10.

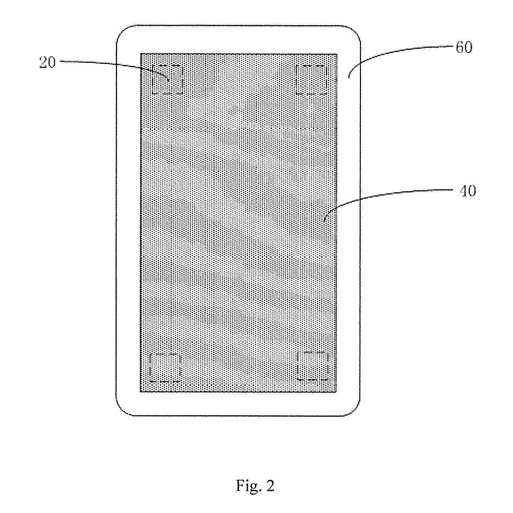

Preferably, as illustrated in Fig. 2, which is a top view of the OLED device, in the present embodiment, the display device is quadratic. Fig. 2 illustrates the display panel 40 disposed under the transparent cover plate 60, the display panel 40 includes four corners, and a pressure sensor 20 is disposed under each of the four corners. Accordingly, a magnitude of the force and the direction and position of the applied force may be judged better.

Preferably, the OLED device of the present embodiment is an AMOLED (Active Matrix Organic Light Emitting Diode) display device.

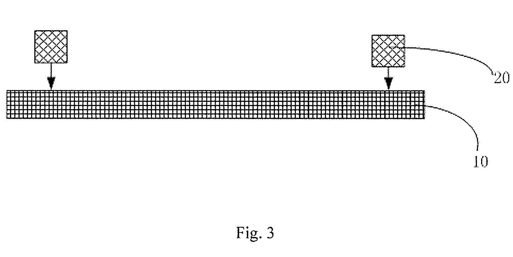

As illustrated in Fig. 3 to Fig. 5, which are drawings of manufacturing process of the OLED device of the present embodiment, the manufacturing process includes steps as follow.

In step 1A, a flexible circuit board 10 and a plurality of pressure sensors 20 are provided, and the plurality of pressure sensors 20 are adhered to an upper surface of the flexible circuit board 10, as illustrated in Fig. 3 (the arrow indicates the adhering direction, similarly hereinafter).

In step I B, a touch screen 50 and a display panel 40 are provided, and a lower surface of the touch screen 50 is attached to an upper surface of the display panel 40.

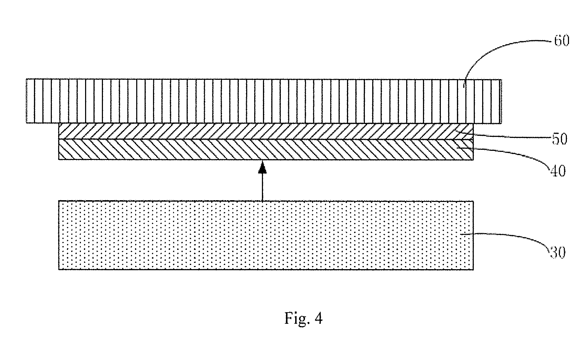

In step 1C, an adhesive layer 30 is adhered to a lower surface of the display panel 40, as illustrated in Fig. 4.

In the steps 1A, 1B, and 1C, the latters A, B and C do not represent the sequential order of the steps. That is, the steps 1A, 1B and 1C are performed separately without any particular order.

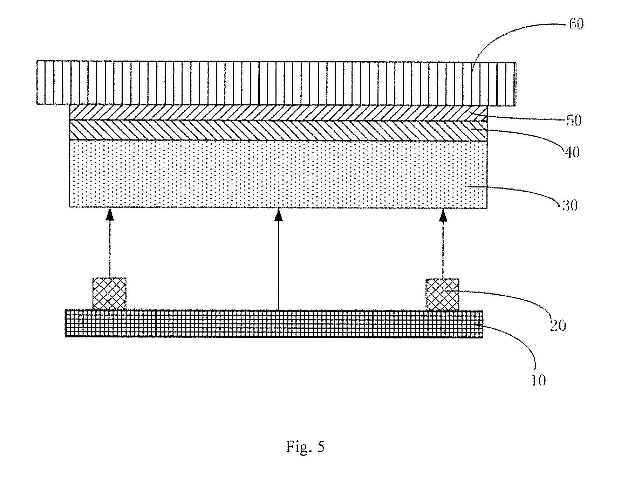

In step 2, an upper layer of the flexible circuit board 10 resulted in step 1A is adhered to a lower surface of the adhesive layer 30 resulted in step 1 B, such that the plurality of pressure sensors 20 are pressed into the adhesive layer 30, thereby being embedded into the adhesive layer 30, as illustrated in Fig. 5.

### Embodiment 2

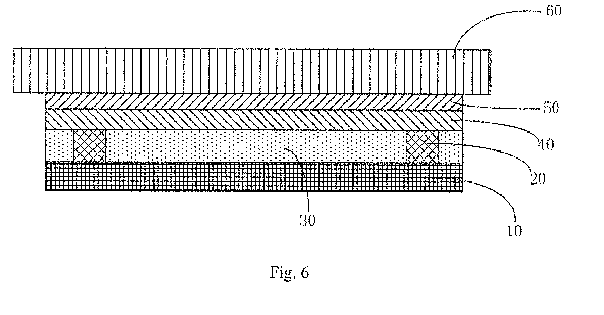

Referring to Fig. 6, which is a structural diagram of the OLED device of embodiment 2 of the present disclosure. As can be seen form Fig. 6, the OLED device of embodiment 2 differs from that of embodiment 1 in that the pressure sensor 20 is disposed in the adhesive layer 30 and is in contact with the display panel 40.

The method for manufacturing the OLED device of embodiment 2 differs from that of embodiment 1 in that: in step 2, the plurality of pressure sensors 20 are embedded into the adhesive layer 30 to direct in contact with the lower surface of the display panel 40.

Except of the foregoing, structure and manufacturing method of the OLED device of embodiment 2 are substantially identical to those of embodiment 1, and thus will not be repeated herein.

The OLED device according to the above embodiments of the present disclosure may be applied in a terminal electronic device such as a smart phone, a tablet computer, and the like. For example, the OLED device may be used in combination with a control button or a switch element of the terminal electronic device, or may be used separately by being embedded into a cover glass or inside a case of the terminal electronic device.

## Claims

1. An organic light emitting display (OLED) device, **characterized in** comprising:
a touch screen (50);
a display panel (40) having an upper surface attached to a lower surface of the touch screen (50) and a lower surface applied with an adhesive layer (30);
a circuit board (10) having an upper surface adhered to the adhesive layer; and
a plurality of pressure sensors (20) disposed in the adhesive layer.

2. The OLED device of claim 1, wherein the plurality of pressure sensors (20) are adhered to the upper surface of the circuit board (10).

3. The OLED device of claim 1, wherein the display panel (40) comprises four corners, and the pressure sensors (20) are respectively disposed under the four corners.

4. The OLED device of claim 3, wherein lower surfaces of the four corners of the display panel (40) are in contact with the pressure sensors (20).

5. The OLED device of any one of claims 1-4, wherein the OLED device is an active matrix organic light emitting diode (AMOLED) display device.

6. The OLED device of any one of claims 1-5, wherein the circuit board (10) is a flexible based circuit board.

7. The OLED device of any one of claims 1-4, further comprising a transparent cover plate (60) disposed on the touch screen (50).

8. The OLED device of claim 7, wherein the transparent cover plate (60) is formed of glass or acryl.

9. A method for manufacturing an organic light emitting display (OLED) device, **characterized in** comprising:
step 1A, providing a circuit board (10) with a plurality of pressure sensors (20) thereon;
step 1 B, providing display panel (40) combined with a touch screen (50),; and
step 2, adhering the circuit board (10) to the display panel (40) through an adhesive layer (30), such that the plurality of pressure sensors (20) are disposed between the circuit board (10) and the display panel (40) and imbedded in the adhesive layer (30).

10. The method of claim 9, after the step 1B further comprising:
step 1C, providing the adhesive layer (30) attached on the display panel (40).

11. The method of claim 9, wherein in the step 2, the plurality of pressure sensors (20) are imbedded into the adhesive layer (30) to direct in contact with the display panel (40).

12. The method of any one of claim 9 to 11, wherein the OLED device is an AMOLED display device.

13. The method of any one of claims 9-12, wherein the circuit board (10) is a flexible based circuit board.

14. An electronic apparatus, **characterized in** comprising the OLED device according to any one of claims 1-8.
